# EUROPEAN PATENT SPECIFICATION

(11) **EP 3 478 039 B1**
(45) Date of publication and mention of the grant of the patent: **06.01.2021**
(21) Application number: 17198787.8
(22) Date of filing: 27.10.2017
(51) Int. Cl.: H05K 5/02, H05K 7/20

(54) **ARRANGEMENT FOR VENTILATING HEAT OUT OF A DEVICE**
ANORDNUNG ZUM ABFÜHREN VON WÄRME AUS EINER VORRICHTUNG
AGENCEMENT DE VENTILATION DE CHALEUR HORS D'UN DISPOSITIF

(43) Date of publication of application: 01.05.2019
(73) Proprietor: Vestel Elektronik Sanayi ve Ticaret A.S., 45030 Manisa (TR)
(72) Inventor: SARIARSLAN, Muhammet Kürsat, 45030 Manisa (TR)
(74) Representative: Kehl, Ascherl, Liebhoff & Ettmayr Patentanwälte Partnerschaft mbB

(56) References cited:
- US-A1- 2005 241 810
- US-B1- 9 735 083

## Description

This invention refers to an arrangement for ventilation from a device according to claim 1, the device according to claim 7, and a method for ventilating heat out of the device according to claim 8.

### Background of the Invention

One of the most common problems with the devices having functional components is production of heat during functioning. In electronic devices due to generation of heat, the operation of electronic circuits is affected negatively. In some cases, the high temperature on the circuits can even cause fire.

Even though, many of such devices producing heat use a heatsink or/and a thermal conductor, however, this can still be insufficient to drive out the enough heat from the device. There should be flow of air created to drive out sufficient heat out of the device. To do that many of these devices uses holes/openings which plays as medium to create air flow out of the device. However, size, position, number of these holes are sometimes not sufficient to achieve enough cooling. On the other side, if the size of the holes is bigger, than there may be issues due to safety of human beings, or to the safety of the devices due to dust, moisture, and other environmental problems.

Chinese Patent Publication No. CN101370109 discloses an embedded TV radiation system which is a structural body with an Impression for accepting a TV set, wherein, a first airway and a second airway communicates with the impression. The first airway leads cold air into the impression, and the second airway lead out the hot air form the inside of the impression, and common indoor air-conditioning/exhausting system is used for cooling the embedded TV set effectively thereby prolonging service life of the TV set.

Further, Japanese Patent Publication No. JP2004364072 discloses a TV receiver for suppressing temperature rise in equipment at low cost and also preventing an electronic circuit and an electronic component from being damaged, and to provide a display device. In the TV receiver using a CRT, ventilation holes are formed in the frame of a main body and also a ventilation hole is formed and directed toward internally mounted heat generating component and the ventilation hole. A rubber film is attached onto the back surface of the main body, so as to clog the ventilation hole. When the TV receiver is used, the film is pulled toward the outer part of the main body and released. Consequently, outer air and inside air in the main body is exchanged through the ventilation holes, so as to perform ventilation inside the main body 1.

Further, US 2005241810 discloses an airflow control apparatus comprising a controllable airflow resistance aligned with an airflow path of a plurality of airflow paths and a sensor as well as a controller coupled to the controllable airflow resistance and to the sensor.

### Object of the Invention

It is therefore the object of the present invention is to provide an arrangement for ventilating heat out of a device having components generating heat, however also to maintain safety of the device as well as humans/objects around the device.

### Description of the Invention

The before mentioned object is solved by an arrangement for ventilation from a device according to claim 1, the device according to claim 7, and a method for ventilating heat out of the device according to claim 8.

An arrangement for providing ventilation from a device comprising a component generating heat while performing its function and a cover encapsulating the component, wherein the cover comprises one or more openings to allow ventilation from an inside environment inside of the device to an outside environment outside to the device, characterized in that, the arrangement comprising means for changing size of at least one of the openings, and a controller adapted to actuate the means to change size of at least one of the openings of the device.

This provides a mechanism for optimally ventilating out the heat out of the device. Such control of opening sizes, and further changing size of only few or all of the openings at a time, provides an optimal control for optimizing the heat flow out of the device, which may also help to ensure safety of the device, and safety of user of the device. In case, if the environmental parameters are destructive to the device in the outside environment, the size of the openings can be reduced to keep the device safe. And, if there are humans/objects around the device than the size of the openings can be reduced to keep the hums or objects safe from the heat ventilated out through the hot air flow out of the device.

According to the invention, the aramgement comprises a proximity sensor adapted to sense presence of an object in proximity to one or more openings, and to generate a proximity data, wherein the controller is adapted to receive and process the proximity data, and to actuate the means for changing size of one or more openings based on the proximity data.

This embodiment is beneficial as it provides a mechanism to change the size of the openings based on proximity of a user or object near to the openings. It is Important to note that, if an human being is near to the opening, in case of higher temperature of air during the heat transfer, it may lead to burn a body of the human being, and highly impact his safety. In furtherance, if a non-living object is nearby which can get affected by heat generated, such gush of hot air may severly affect it's functioning. Further, if the object or human being is in proximmity, it may also hinder the proper air flow from inside environment to the outside environment, which can affect the safety and functioning of the device too.

Further preferred embodiments are subject-matter of dependent claims and/or of the following specification parts.

According to a preferred embodiment of the invention, the arrangement comprises a motion sensor adapted to sense motion of the object in proximity to one or more openings, and to generate a motion data, wherein the controller is adapted to receive and process the motion data, and to actuate the means for changing size of one or more openings based on the motion data.

This embodiment is helpful, as it provides a reduced false positive with respect to proximity data for determining presence of the object or human being near to the openings. Also, it can also provide opportunity to keep the proximity sensor in inactive mode, untill the time motion sensor detects motion. Once the motion sensor detects the motion, the proximity sensor can be activated to sense object or human being in proximity.

According to another embodiment of the invention, the arrangement comprises an environmental sensor adapted to sense at least one of environmental parameters in the inside environment, or the outside environment, or both, and to generate an environmental data, wherein the controller is adapted to receive and process the environmental data, and to actuate the means for changing size of one or more openings based on the environmental data.

This embodiment is beneficial as it provides for mechanism to detect the environmental parameters, and based on those parameters to determine whether it is safe to widen the openings, and if it is unsafe to narrow down the openings, so as to protect the device, and further actuates the means accordingly.

According to a further embodiment of the arrangement, the environmental parameters are at least one of a temperature, dust, humidity, or moisture, or combination thereof.

This embodiment is helpful, as it provides for a mechanism to keep safe the device against various environmental parameters like dust, humidity, moisture, temperature, etc.

According to a further preferred embodiment of the invention, the arrangement comprises a set of movable elements corresponding to each opening, the movable elements are placed in proximity to each of the openings, and each of the element is in movement coupling to each of the openings for covering or uncovering the openings, partially or completely, to change size of the openings, wherein the controller is adapted control movement of each element, either independently or cumulatively.

This embodiment is beneficial, as it provides for mechanism to individually control each of the openings for changing its size. This embodiment is specifically useful, when the devices are big, and at a different part of device there may be a difference in environmental parameters, or at some parts the objects or human being are proximity, and to some part there is no one in proximity. In such scenario, if there are openings provided at multiple parts of the cover of the device, the size of the opening can be individually managed to ensure safety of device and objects, as well efficient heat transfer from inside environment to the outside environment.

According to another embodiment of the invention, the arrangement comprises a shutter comprising multiple holes, each hole corresponds to each of the opening, the shutter is placed in such a way so that each of the holes is in proximity to the opening, the shutter is in movement coupling to the openings for covering or uncovering the openings, partially or completely, to change size of the openings, wherein the controller is adapted to control movement of the shutter to change the size of all the opening together to which it's holes are in coupling.

This embodiment is beneficial, as it provides for mechanism to control multiple openings at a time.

The before mentioned object is also solved by a device of claim 7. The device comprising a component generating heat while performing its function and a cover, wherein the cover comprises one or more openings to allow ventilation from an inside environment inside of the device to an outside environment outside to the device, characterized in that, the device comprising the arrangement according to any of the claims 1 to 6.

The before mentioned object is also solved by a method of claim 8. The method for ventilating heat out of a device comprising a component generating heat while performing its function and a cover, wherein the cover comprises one or more openings to allow ventilation from an inside environment inside of the device to an outside environment outside to the device, the method comprising:
- actuating means for changing size of at least one of the openings of the device by a controller; and
- changing size of at least one of the openings by the means,
wherein the cover (3) encapsulates the component (2), and wherein
the method comprises receiving and processing at least one of a proximity data, a motion data, or an environmental data, or combination thereof, by the controller, wherein the proximity data relates to proximity of an object to one or more openings of the device, the motion data relates to motion of the object in proximity to one or more openings of the device, and the environmental data relates to one of environmental parameters in the inside or outside environment, wherein the controller actuates the means to change size of one or more openings based on at least one of a proximity data, a motion data, or an environmental data, or a combination thereof.

According to a preferred embodiment of the method, the method comprises steps of:
- processing the environmental data by the controller by comparing the environmental data with an environmental threshold value, and if the environmental data is more than the environmental threshold value than the controller reduces size of the openings;
- if the environmental data is less than the threshold value, processing the proximity data by the controller by comparing the proximity data with a proximity threshold value, and if the proximity data is less than the proximity threshold value, than actuating the means by the controller and reducing the size of the openings by the means, otherwise actuating the means by the controller, and depending thereon increasing size of the openings by the means.

According to another embodiment of the method, the method comprises steps of:
- if the environmental data is less than the threshold value, than processing the motion data by the controller, and if the object is in motion, than processing the proximity data by the controller by comparing the proximity data with a proximity threshold value, and if the proximity data is less than the proximity threshold value, than actuating the means by the controller, and reducing size of the openings, otherwise actuating the means by the controller, and increasing size of the openings.

Further benefits, goals and features of the present invention will be described by the following specification of the attached figures, in which components of the invention are exemplarily illustrated. Components of the devices and method according to the inventions, which match at least essentially with respect to their function, can be marked with the same reference sign, wherein such components do not have to be marked or described in all figures.

The invention is just exemplarily described with respect to the attached figure in the following.

### Brief Description of the Drawings

Fig. 1 illustrates a schematic diagram of an arrangement for ventilating a device.
Fig. 2a illustrates a set of movable elements in coupling to the openings of a cover of the device, when openings are uncovered.
Fig 2b illustrates the set of movable elements in coupling to the openings of the cover of the device, when the openings are partially covered.
Fig 2c illustrates the set of movable elements in coupling to the openings of the cover of the device, when some openings are partially covered, some of the openings are uncovered, and remaining openings are completely covered.
Fig 3 illustrates a shutter in coupling to the openings of the cover of the device, when some openings are partially covered.
Fig 4 illustrates a flowchart showing functioning of the arrangement, according to one embodiment of the invention.

### Detailed Description of the Drawings

The present invention focuses on ventilating heat out of a device having a component which produces heat. Generally, these devices have a cover and the component is encapsulated inside the cover with minimal or no place for ventilating out the air surrounding the component. The surrounding air gets heated up due to the heat generation by the electric component. If this heat does not gets ventilated it substantially affect the functioning of the component and further the whole device. Overheating inside the device may also result in damaging the device. The invention is provided with an arrangement which helps in optimizing size of the openings provided onto the cover, so that maximum heat can be ventilated out of the device, however still keeping it safe for any user or animal moving, sitting or standing around the device, also keeping the device's component safe with respect to the environmental parameters like heat, moisture, dust, etc.

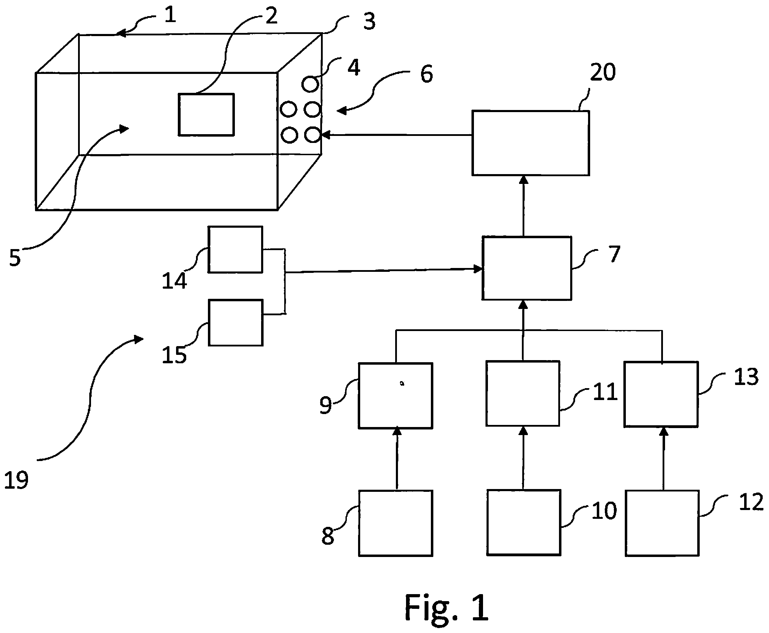

Fig. 1 shows a schematic diagram of the arrangement 19 for ventilating the device 1. The device 1 includes a component 2 generating heat while performing its function and a cover 3 encapsulating the component 2. The cover 3 has a set of openings 4 to allow ventilation from an inside environment 5 inside of the device 1 to an outside environment 6 outside to the device 1. The openings 4 can be placed at one or more side of the cover 3 of the device 1. It is recommended to provide the opening 4 to at least be placed on the side of the cover 3 nearest to the component 2.

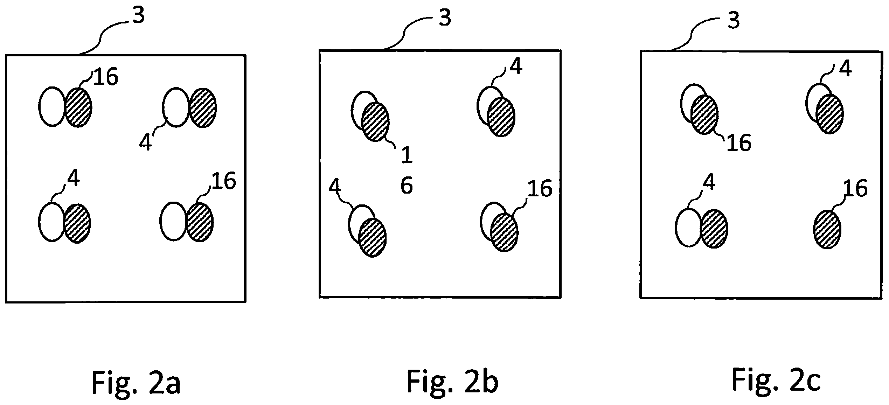

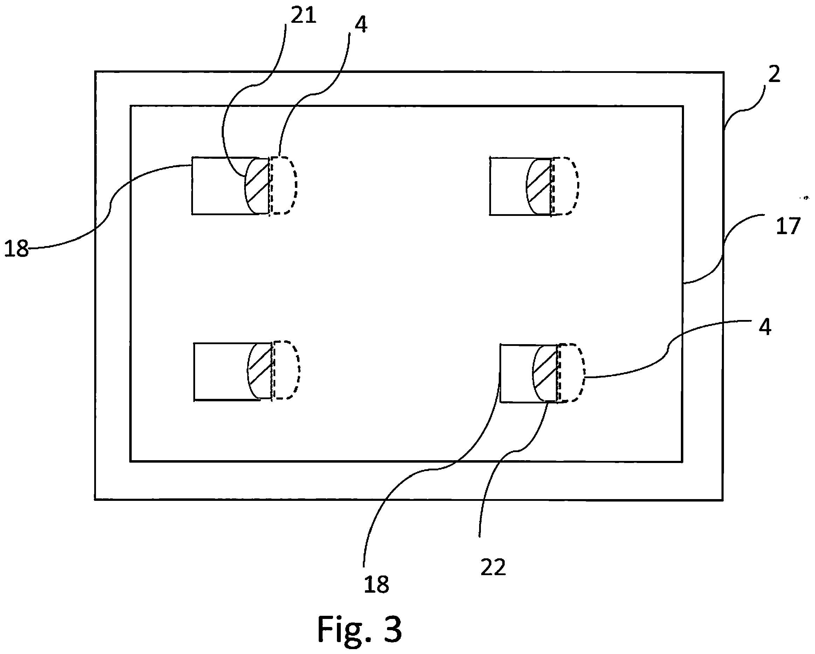

The arrangement 19 includes means 20 for changing size of at least one of the openings 4. The arrangement 19 also includes a controller 7 which actuates the means 20 and changes size of at least one of the openings 4 provided on cover 3 of the device 1. One means 20 of the changing the size of the openings 4 can be a stretcher adapted stretch the cover 3, which is flexible, to increase or decrease size of the openings 4. Other means 20 for changing size of the openings 4 are illustrated in Figs. 2a-c, and Fig. 3.

The arrangement 19 also includes a proximity sensor 8 which senses presence of an object in proximity to the openings 4, and generates a proximity data 9. The controller 7 receives and processes the proximity data 9. Based on the processing of the proximity data 9, and the controller actuates the means 20 for changing size of the openings 4. In one embodiment, the proximity sensor 8 is not provided, rather the user of the device 1 uses his judgement to manually handle the controller 7 to actuate the means 20 for changing the openings 4 of the cover 3.

The arrangement 19 also includes a motion sensor 10 which senses motion of the object in proximity to the openings 4, and generates a motion data 11. The controller 7 receives and processes the motion data 11. Based on processing of the motion data 11, the controller 7 actuates the means 20 for changing size of the openings 4. In one embodiment, the motion sensor 10 is not provided, rather the user of the device 1 uses his judgement to manually handle the controller 7 to actuate the means 20 for changing the openings 4 of the cover 3.

The arrangement 19 also includes an environmental sensor 12 which senses at least one of environmental parameters in the outside environment 6 and generates an environmental data 13. The controller 7 receives and processes the environmental data 13. Based on processing of the environmental data 13, the controller 7 actuates the means 20 for changing size of the openings 4. In one embodiment, the environmental sensor 12 is not provided, rather the user of the device 1 uses his judgement to manually handle the controller 7 to actuate the means 20 for changing the openings 4 of the cover 3. The environmental parameter can be temperature, dust, humidity, or moisture, or combination thereof.

Fig. 2a-c shows a set of movable elements 16 in coupling to the openings 4 of the cover 3. The set of movable elements 16 corresponds to each of the openings 4 provided on the cover 3. The movable elements 16 are placed in proximity to each of the openings 4. The movable elements 16 are in movement coupling to each of the openings 4 for covering or uncovering the openings 4. The movable elements 16 can move, partially or completely, to cover the openings 4, so that the size of the openings 4 is changed. Each of the movable elements 16 can individually be controlled for movement by the controller 7. More than one movable elements 8 can also be controlled cumulatively by the controller 7 for changing the size of the openings 4, by partially or completely covering or uncovering the movable elements 16. The movable elements 16 can move either around one of an axis passing through a circumference of the opening 4, or the movable elements 16 can laterally move along a diameter of the openings 4. The openings 4 shown in Figs. 2a-c are circular, however, the openings 4 can have any other geometry, like rectangle, square, triangle, pentagon, etc. The movable elements 16 are having at least size equal to or bigger than that of the size of the openings 4. The geometry of the movable elements 16 can be complimentary to the geometry of the openings 4. The geometry of the movable elements 16 can be different with respect to the geometry of the openings 4, however, the geometry of the movable elements 16 shall be such that it can cover the openings 4 completely. Fig. 2a shows the movable elements 16 placed in such a way, that openings 4 are completely uncovered. Fig. 2b shows the set of movable elements 16 partially covering the openings 4. In the Figs. 2a and 2b, the controller 7 is cumulatively controlling all the movable elements 16. Fig 2c shows the set of movable elements 16 partially covering some of the openings 4, uncovering some of the openings 4 completely, and completely covering remaining of the openings 6. In this figure, the controller 7 is controlling some of the movable elements 16 individually, and some of the movable elements 16 cumulatively.

Fig 3 shows another means for changing the size of the openings 4. The means are provided in form of a shutter 17. The shutter 17 has multiple holes 18, such that each hole 18 is corresponds to each of the opening 4. The shutter 17 is placed in such a way so that each of the holes 18 is in proximity to the opening 4. The shutter 17 is in movement coupling to the openings 4 for covering or uncovering the openings 4. The openings can be covered partially or completely to change size of the openings 4. When the shutter 17 moves, part of the holes 18 overlaps to the openings 4 to partially cover the openings 4, while the holes 18 totally overlaps the opening to completely uncover the openings 4, The size of the holes 18 can be greater than or equal to size of the opening 4. The geometry of the holes 18 can be complimentary to the geometry of the openings 4. The geometry of the holes 18 can be different to that of the openings 4, however the geometry of the holes 18 should be such that to totally uncover the holes 18 when triggered by the controller. In this embodiment, a plurality of openings 4 are controlled for changing the size by one shutter 17 in one go. If there are different set of openings 4 required to be managed differently, multiple shutters 17 can be provided which can individually be controlled for movement.

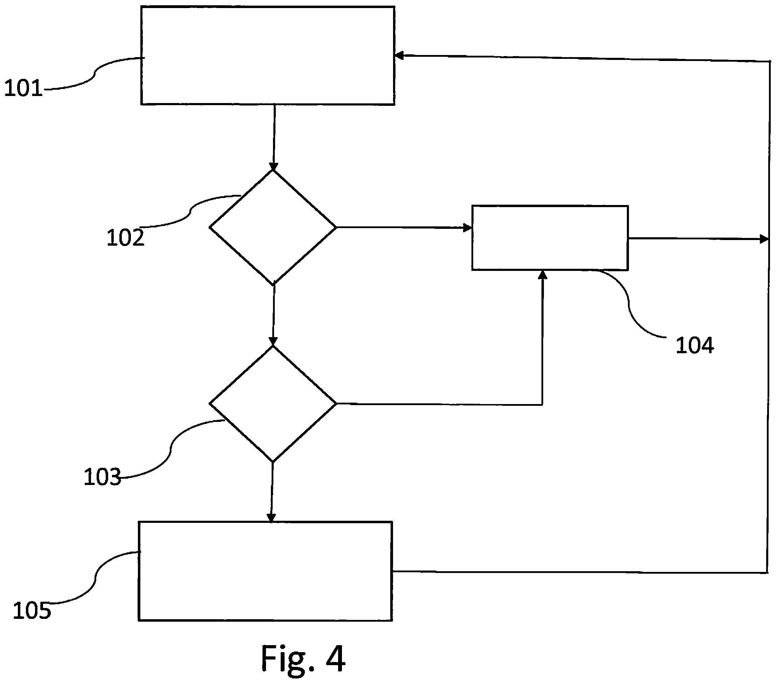

Fig 4 shows a flowchart showing functioning of the arrangement. In step 101, the proximity sensor generates the proximity data, and the environmental sensor generates the environmental data, and sends them to the controller. In step 102, the controller compares the environmental data to the environmental threshold value, and if the environmental data is higher with respect to the environmental threshold value, moving the flow to step 104, otherwise to step 103. In step 103, the controller compares the proximity data to the proximity threshold value, and if the proximity data is lesser than the proximity threshold value, then moving thee flow to step 104, otherwise moving the flow to step 105. In step 104, the controller actuates the means to reduce the size of the openings, and further move the flow to step 101. In step 105, the controller actuates the means to increase the size of the openings, and further move the flow to step 101.

This invention can be implemented in all the devices in which there is high temperature generation inside, for example: electronic devices, automobiles, engines, etc.

Thus, the present description discloses an arrangement for providing ventilation from a device 1 which includes a component 2 generating heat while performing its function and a cover 3 encapsulating the component 2. The cover 3 comprises one or more openings 4 to allow ventilation from an inside environment 5 inside of the device 1 to an outside environment 6 outside to the device 1. The arrangement further includes means 20 for changing size of at least one of the openings 4, and a controller 7 which actuates the means 20 to change size of at least one of the openings 4 of the device 1.

### List of reference numbers

- 1: device
- 2: component
- 3: cover
- 4: openings
- 5: inside environment
- 6: outside environment
- 7: controller
- 8: proximity sensor
- 9: proximity data
- 10: motion sensor
- 11: motion data
- 12: environmental sensor
- 13: environmental data
- 14: environmental threshold value
- 15: proximity threshold value
- 16: movable elements
- 17: shutter
- 18: holes
- 19: arrangement
- 20: means for changing size of the openings
- 21: remaining part of the opening
- 101: Step for collecting the environmental parameter and user proximity
- 102: Step for checking the environmental data
- 103: Step for checking the proximity data
- 104: Step for decreasing size of the openings
- 105: Step for decreasing size of the openings

## Claims

1. An arrangement (19) for providing ventilation from an electronics device (1) comprising a component (2) generating heat while performing its function and a cover (3), wherein the cover (3) comprises one or more openings (4) to allow ventilation from an inside environment (5) inside of the device (1) to an outside environment (6) outside to the device (1), the arrangement (19) comprising:
- means (20) for changing size of at least one of the openings (4); and
- a controller (7) adapted to actuate the means (20) to change size of at least one of the openings (4) of the device (1)
**characterized in that**
the cover (3) encapsulates the component (2), and wherein the arrangement comprises a proximity sensor (8) which is adapted to sense presence of an object in proximity to one or more of the openings (4), and which generates a proximity data (9),
wherein the controller (7) is adapted to receive and process the proximity data (9) and to actuate the means (20) for changing size of the one or more openings (4) based on the proximity data (9).

2. The arrangement (19) according to claim 1 further comprising:
- a motion sensor (10) adapted to sense motion of the object in proximity to the one or more openings (4), and to generate a motion data (11),
wherein the controller (7) is adapted to receive and process the motion data (121), and to actuate the means (20) for changing size of the one or more openings (4) based also on the motion data (11).

3. The arrangement (19) according to claims 1 or 2 further comprising:
- an environmental sensor (12) adapted to sense at least one of environmental parameters in the inside environment (5), or the outside environment (6), or both, and to generate an environmental data (13),
wherein the controller (7) is adapted to receive and process the environmental data (13), and to actuate the means (20) for changing size of the one or more openings (4) based also on the environmental data (13).

4. The arrangement (19) according to the claim 3, wherein the environmental parameters are at least one of a temperature, dust, humidity, or moisture, or combination thereof.

5. The arrangement (19) according to any of the claims 1 to 4 comprising:
- a set of movable elements (16) corresponding to each opening (4), the movable elements (16) are placed in proximity to each of the openings (4), and each of the movable element (16) is in movement coupling to each of the openings (4) for covering or uncovering the openings (4), partially or completely, to change size of the openings (4), wherein the controller (7) is adapted control movement of each movable element (16), either independently or cumulatively.

6. The arrangement (19) according to any of the claims 1 to 5 comprising:
- a shutter (17) comprising multiple holes (18), each hole (18) corresponds to each of the opening (4), the shutter (17) is placed in such a way so that each of the holes (18) is in proximity to the opening (4), the shutter (17) is in movement coupling to the openings (4) for covering or uncovering the openings (4), partially or completely, to change size of the openings (4), wherein the controller (7) is adapted control movement of the shutter (17) to change the size of all the openings (4) together to which it's holes (18) are in coupling.

7. An electronic device (1) comprising a component (2) generating heat while performing its function and a cover (3), wherein the cover comprises one or more openings (4) to allow ventilation from an inside environment (5) inside of the device (1) to an outside environment (6) outside to the device (1), **characterized in that,** the device (1) comprising the arrangement (19) according to any of the claims 1 to 6.

8. A method for ventilating heat out of an electronic device (1) comprising the arrangement 19 according to any of the claims 1 to 6,
- receiving and processing at least one of a proximity data (9), a motion data (11), or an environmental data (13), or combination thereof, by the controller (7), wherein the proximity data (9) relates to proximity of an object to one or more openings (4) of the device (1), the motion data (11) relates to motion of the object in proximity to one or more openings (4) of the device (1), and the environmental data (13) relates to one of environmental parameters in the inside environment (5) or the outside environment (6),
wherein the controller (7) actuates the means (20) to change size of one or more openings (4) based on at least one of the proximity data (9), the motion data (11), or the environmental data (13), or a combination thereof.

9. The method according to the claim 8 comprising:
- processing the environmental data (13) by the controller (7) by comparing the environmental data (13) with an environmental threshold value (14), and if the environmental data (13) is more than the environmental threshold value (14) than the controller (7) reduces size of the openings (4); and
- if the environmental data (13) is less than the environmental threshold value (14), processing the proximity data (9) by the controller (7) by comparing the proximity data (9) with a proximity threshold value (15), and if the proximity data (9) is less than the proximity threshold value (15), than actuating the means (20) by the controller (7), and reducing size of the openings (4) by the means (20), otherwise actuating the means (20) by the controller (7), and increasing size of the openings (4) by the means (20).

10. The method according to claim 9 comprising:
- if the environmental data (13) is less than the environmental threshold value (14), than processing the motion data (11) by the controller (7), and if the object is in motion, than processing the proximity data (9) by the controller (7) by comparing the proximity data (9) with a proximity threshold value (15), and if the proximity data (9) is less than the proximity threshold value (15), than actuating the means (20) by the controller (7), and reducing size of the openings (4), otherwise actuating the means (20) by the controller (7), and increasing size of the openings (4).

## Patentansprüche

1. Eine Anordnung (19) zum Bereitstellen einer Belüftung von einer elektronischen Vorrichtung (1), die eine Komponente (2), die Wärme erzeugt, während sie ihre Funktion ausführt, und eine Abdeckung (3) umfasst, wobei die Abdeckung (3) eine oder mehrere Öffnungen (4) aufweist, um eine Belüftung von einer inneren Umgebung (5) innerhalb der Vorrichtung (1) zu einer äußeren Umgebung (6) außerhalb der Vorrichtung (1) zu ermöglichen, wobei die Anordnung (19) umfasst:
- Mittel (20) zum Ändern der Größe von mindestens einer der Öffnungen (4); und
- einen Aktuator (7), der geeignet ist, die Mittel (20) zur Änderung der Größe mindestens einer der Öffnungen (4) der Vorrichtung (1) zu betätigen
**dadurch gekennzeichnet, dass**
die Abdeckung (3) die Komponente (2) einkapselt, und wobei die Anordnung einen Näherungssensor (8) aufweist, der geeignet ist, die Anwesenheit eines Objekts in der Nähe einer oder mehrerer der Öffnungen (4) zu erfassen, und der Näherungsdaten (9) erzeugt,
wobei die Steuereinheit (7) dazu ausgelegt ist, die Näherungsdaten (9) zu empfangen und zu verarbeiten und die Mittel (20) zum Ändern der Größe der einen oder mehreren Öffnungen (4) auf der Grundlage der Näherungsdaten (9) zu betätigen.

2. Die Anordnung (19) nach Anspruch 1 weist ferner auf:
- einen Bewegungssensor (10), der geeignet ist, die Bewegung des Objekts in der Nähe der einen oder mehreren Öffnungen (4) zu erfassen und Bewegungsdaten (11) zu erzeugen,
wobei die Steuereinheit (7) dazu ausgelegt ist, die Bewegungsdaten (121) zu empfangen und zu verarbeiten und die Mittel (20) zum Ändern der Größe der einen oder mehreren Öffnungen (4) auf der Grundlage der Bewegungsdaten (11) zu betätigen.

3. Die Anordnung (19) nach Anspruch 1 oder 2 weist ferner auf:
- einen Umgebungssensor (12), der geeignet ist, mindestens einen der Umgebungsparameter in der inneren Umgebung (5) oder der äußeren Umgebung (6) oder beide zu erfassen und Umgebungsdaten (13) zu erzeugen,
wobei die Steuereinheit (7) dafür ausgelegt ist, die Umgebungsdaten (13) zu empfangen und zu verarbeiten und die Mittel (20) zum Ändern der Größe der einen oder mehreren Öffnungen (4) auch auf der Grundlage der Umgebungsdaten (13) zu betätigen.

4. Anordnung (19) nach Anspruch 3, wobei die Umgebungsparameter mindestens einer der Parameter Temperatur, Staub, Feuchtigkeit oder Feuchtigkeit oder eine Kombination davon sind.

5. Die Anordnung (19) nach einem der Ansprüche 1 bis 4 weist auf:
- einen Satz beweglicher Elemente (16), die jeder Öffnung (4) entsprechen, wobei die beweglichen Elemente (16) in der Nähe jeder der Öffnungen (4) angeordnet sind, und jedes der beweglichen Elemente (16) in Bewegungskopplung mit jeder der Öffnungen (4) steht, um die Öffnungen (4) teilweise oder vollständig abzudecken oder freizugeben, um die Größe der Öffnungen (4) zu ändern, wobei die Steuerung (7) angepasst ist, um die Bewegung jedes beweglichen Elements (16) entweder unabhängig oder kumulativ zu steuern.

6. Die Anordnung (19) nach einem der Ansprüche 1 bis 5 weist auf:
- einen Verschluss (17), der mehrere Löcher (18) aufweist, wobei jedes Loch (18) jeder der Öffnungen (4) entspricht, wobei der Verschluss (17) so angeordnet ist, dass jedes der Löcher (18) in der Nähe der Öffnung (4) ist, wobei der Verschluss (17) in Bewegung ist und mit den Öffnungen (4) gekoppelt ist, um die Öffnungen (4) abzudecken oder freizugeben, teilweise oder vollständig, um die Größe der Öffnungen (4) zu ändern, wobei die Steuerung (7) so angepasst ist, dass sie die Bewegung des Verschlusses (17) steuert, um die Größe aller Öffnungen (4) zusammen zu ändern, mit denen ihre Löcher (18) in Verbindung stehen.

7. Elektronische Vorrichtung (1), umfassend eine Komponente (2), die Wärme erzeugt, während sie ihre Funktion ausführt, und eine Abdeckung (3), wobei die Abdeckung eine oder mehrere Öffnungen (4) aufweist, um eine Belüftung von einer inneren Umgebung (5) innerhalb der Vorrichtung (1) zu einer äußeren Umgebung (6) außerhalb der Vorrichtung (1) zu ermöglichen, **dadurch gekennzeichnet, dass** die Vorrichtung (1) die Anordnung (19) nach einem der Ansprüche 1 bis 6 aufweist.

8. Verfahren zum Abführen von Wärme aus einer elektronischen Vorrichtung (1), welche die Anordnung nach einem der Ansprüche 1 bis 6 aufweist:
- Empfangen und Verarbeiten von mindestens einem von Näherungsdaten (9), Bewegungsdaten (11) oder Umgebungsdaten (13) oder einer Kombination davon durch die Steuerung (7), wobei die Näherungsdaten (9) sich auf die Nähe eines Objekts zu einer oder mehreren Öffnungen (4) der Vorrichtung (1) beziehen, die Bewegungsdaten (11) sich auf die Bewegung des Objekts in der Nähe einer oder mehrerer Öffnungen (4) der Vorrichtung (1) beziehen und die Umgebungsdaten (13) sich auf einen von Umgebungsparametern in der inneren Umgebung (5) oder der äußeren Umgebung (6) beziehen,
wobei die Steuerung (7) die Aktuatoren (20) betätigt, um die Größe einer oder mehrerer Öffnungen (4) auf der Grundlage von mindestens einem der Näherungsdaten (9), der Bewegungsdaten (11) oder der Umgebungsdaten (13) oder einer Kombination davon zu ändern.

9. Das Verfahren nach Anspruch 8 weist auf:
- Verarbeiten der Umgebungsdaten (13) durch den Controller (7) durch Vergleichen der Umgebungsdaten (13) mit einem Umgebungsschwellenwert (14), und wenn die Umgebungsdaten (13) größer als der Umgebungsschwellenwert (14) sind, reduziert der Controller (7) die Größe der Öffnungen (4); und
- wenn die Umgebungsdaten (13) kleiner als der Umgebungsschwellwert (14) sind, Verarbeiten der Näherungsdaten (9) durch die Steuereinheit (7) durch Vergleichen der Näherungsdaten (9) mit einem Näherungsschwellwert (15), und wenn die Näherungsdaten (9) kleiner als der Näherungsschwellwert (15) sind, Betätigen der Mittel (20) durch die Steuereinheit (7), und Verringern der Größe der Öffnungen (4) durch die Mittel (20), andernfalls Betätigen der Mittel (20) durch die Steuereinheit (7), und Vergrößern der Größe der Öffnungen (4) durch die Mittel (20).

10. Das Verfahren nach Anspruch 9 weist auf:
- wenn die Umgebungsdaten (13) kleiner als der Umgebungsschwellwert (14) sind, dann Verarbeitung der Bewegungsdaten (11) durch die Steuerung (7), und wenn das Objekt in Bewegung ist, dann Verarbeitung der Näherungsdaten (9) durch die Steuerung (7) durch Vergleich der Näherungsdaten (9) mit einem Näherungsschwellwert (15), und wenn die Annäherungsdaten (9) kleiner als der Annäherungsschwellenwert (15) sind, als das Betätigen der Mittel (20) durch die Steuerung (7) und das Verringern der Größe der Öffnungen (4), andernfalls das Betätigen der Mittel (20) durch die Steuerung (7) und das Vergrößern der Größe der Öffnungen (4).

## Revendications

1. Dispositif (19) pour fournir une ventilation à partir d'un dispositif électronique (1) comprenant un composant (2) générant de la chaleur tout en remplissant sa fonction et un couvercle (3), dans lequel le couvercle (3) comprend une ou plusieurs ouvertures (4) pour permettre la ventilation d'un environnement intérieur (5) à l'intérieur du dispositif (1) vers un environnement extérieur (6) à l'extérieur du dispositif (1), l'agencement (19) comprenant :
- des moyens (20) pour modifier la taille d'au moins une des ouvertures (4) ; et
- un contrôleur (7) adapté pour actionner les moyens (20) permettant de modifier la taille d'au moins une des ouvertures (4) du dispositif (1)
**caractérisé en ce que**
le couvercle (3) encapsule le composant (2), et dans lequel l'agencement comprend un capteur de proximité (8) qui est adapté pour détecter la présence d'un objet à proximité d'une ou plusieurs des ouvertures (4), et qui génère une donnée de proximité (9),
dans lequel le contrôleur (7) est adapté pour recevoir et traiter les données de proximité (9) et pour actionner les moyens (20) permettant de modifier la taille d'une ou plusieurs ouvertures (4) en fonction des données de proximité (9).

2. Le dispositif (19) selon la revendication 1 comprenant en outre :
- un capteur de mouvement (10) adapté pour détecter le mouvement de l'objet à proximité d'une ou plusieurs ouvertures (4) et pour générer des données de mouvement (11),
dans lequel le contrôleur (7) est adapté pour recevoir et traiter les données de mouvement (121), et pour actionner les moyens (20) pour modifier la taille d'une ou plusieurs ouvertures (4) en fonction des données de mouvement (11).

3. Le dispositif (19) selon les revendications 1 ou 2 comprend en outre :
- un capteur d'environnement (12) adapté pour détecter au moins un des paramètres environnementaux dans l'environnement intérieur (5), ou l'environnement extérieur (6), ou les deux, et pour générer une donnée environnementale (13),
dans lequel le contrôleur (7) est adapté pour recevoir et traiter les données environnementales (13), et pour actionner les moyens (20) de modification de la taille d'une ou plusieurs ouvertures (4) sur la base également des données environnementales (13).

4. La disposition (19) selon la revendication 3, dans laquelle les paramètres environnementaux sont au moins l'un d'une température, de la poussière, de l'humidité ou d'une combinaison de ceux-ci.

5. La disposition (19) selon l'une des revendications 1 à 4 comprenant :
- un ensemble d'éléments mobiles (16) correspondant à chaque ouverture (4), les éléments mobiles (16) sont placés à proximité de chacune des ouvertures (4), et chacun des éléments mobiles (16) est en couplage de mouvement avec chacune des ouvertures (4) pour couvrir ou découvrir les ouvertures (4), partiellement ou complètement, pour changer la taille des ouvertures (4), dans lequel le contrôleur (7) est adapté pour contrôler le mouvement de chaque élément mobile (16), soit indépendamment soit de manière cumulative.

6. Le dispositif (19) selon l'une des revendications 1 à 5 comprenant :
- un volet (17) comprenant plusieurs trous (18), chaque trou (18) correspond à chacune des ouvertures (4), le volet (17) est placé de telle manière que chacun des trous (18) est à proximité de l'ouverture (4), le volet (17) est en mouvement en étant couplé aux ouvertures (4) pour couvrir ou découvrir les ouvertures (4), partiellement ou complètement, pour changer la taille des ouvertures (4), dans lequel le contrôleur (7) est adapté pour contrôler le mouvement du volet (17) afin de changer la taille de toutes les ouvertures (4) ensemble auxquelles ses trous (18) sont couplés.

7. Un dispositif électronique (1) comprenant un composant (2) générant de la chaleur tout en remplissant sa fonction et un couvercle (3), dans lequel le couvercle comprend une ou plusieurs ouvertures (4) pour permettre la ventilation d'un environnement intérieur (5) à l'intérieur du dispositif (1) vers un environnement extérieur (6) à l'extérieur du dispositif (1), **caractérisé en ce que**, le dispositif (1) comprenant l'agencement (19) selon l'une quelconque des revendications 1 à 6.

8. Une méthode pour ventiler la chaleur hors d'un dispositif électronique (1) comprenant l'agencement selon l'une quelconque des revendications 1 à 6 :
- la réception et le traitement d'au moins une donnée parmi une donnée de proximité (9), une donnée de mouvement (11) ou une donnée d'environnement (13), ou une combinaison de celles-ci, par le contrôleur (7), dans lequel la donnée de proximité (9) concerne la proximité d'un objet par rapport à une ou plusieurs ouvertures (4) du dispositif (1), la donnée de mouvement (11) concerne le mouvement de l'objet à proximité d'une ou plusieurs ouvertures (4) du dispositif (1), et la donnée d'environnement (13) concerne un des paramètres d'environnement dans l'environnement intérieur (5) ou l'environnement extérieur (6),
dans lequel le contrôleur (7) actionne les moyens (20) pour modifier la taille d'une ou plusieurs ouvertures (4) sur la base d'au moins une des données de proximité (9), des données de mouvement (11) ou des données environnementales (13), ou d'une combinaison de celles-ci.

9. La méthode selon la revendication 8 comprenant :
- le traitement des données environnementales (13) par le contrôleur (7) en comparant les données environnementales (13) avec une valeur seuil environnementale (14), et si les données environnementales (13) sont supérieures à la valeur seuil environnementale (14), le contrôleur (7) réduit la taille des ouvertures (4) ; et
- si les données environnementales (13) sont inférieures à la valeur seuil environnementale (14), traitement des données de proximité (9) par le contrôleur (7) en comparant les données de proximité (9) avec une valeur seuil de proximité (15), et si les données de proximité (9) sont inférieures à la valeur seuil de proximité (15), actionnement des moyens (20) par le contrôleur (7), et réduction de la taille des ouvertures (4) par les moyens (20), sinon actionnement des moyens (20) par le contrôleur (7), et augmentation de la taille des ouvertures (4) par les moyens (20).

10. La méthode selon la revendication 9 comprenant :
- si les données environnementales (13) sont inférieures à la valeur seuil environnementale (14), le traitement des données de mouvement (11) par le contrôleur (7), et si l'objet est en mouvement, le traitement des données de proximité (9) par le contrôleur (7) en comparant les données de proximité (9) avec une valeur seuil de proximité (15), et si les données de proximité (9) sont inférieures à la valeur seuil de proximité (15), que l'actionnement des moyens (20) par le contrôleur (7), et la réduction de la taille des ouvertures (4), sinon l'actionnement des moyens (20) par le contrôleur (7), et l'augmentation de la taille des ouvertures (4).
